Europäisches Patentamt

European Patent Office

Office européen des brevets

(11) Numéro de publication: **0 380 380**

**A1**

(12) # DEMANDE DE BREVET EUROPEEN

(21) Numéro de dépôt: 90400063.5

(51) Int. Cl.⁵: **H01L 33/00, H01L 27/15, H01S 3/25**

(22) Date de dépôt: **09.01.90**

(30) Priorité: **20.01.89 FR 8900710**

(43) Date de publication de la demande:
**01.08.90 Bulletin 90/31**

(84) Etats contractants désignés:
**DE GB**

(71) Demandeur: **ETAT FRANCAIS représenté par le Ministre des Postes, Télécommunications et de l'Espace (CENTRE NATIONAL D'ETUDES DES TELECOMMUNICATIONS) 38-40 rue du Général Leclerc F-92131 Issy-les-Moulineaux(FR)**

(72) Inventeur: **Menigaux, Louis 85, avenue des Tilleuls F-91440 Bures-sur-Yvette(FR)**
Inventeur: **Dugrand, Louis 6, boulevard d'Alsace Lorraine F-77500 Chelles(FR)**

(74) Mandataire: **Plaçais, Jean-Yves et al Cabinet Netter, 40, rue Vignon F-75009 Paris(FR)**

(54) **Procédé de fabrication d'un dispositif semi-conducteur quasi-plat susceptible d'effet laser multi-longueurs d'onde et dispositif correspondant.**

(57) A partir d'un empilement en double hétérostructure supporté par un substrat (S-2) présentant des marches, on obtient, après nivellement de l'empilement et diffusion à travers une surface plane, un dispositif semi-conducteur susceptible d'effet laser multi-longueurs d'onde dont les différentes jonctions (J1-2, J2-2, J3-2) sont situées dans un plan parallèle à la semelle du substrat.

EP 0 380 380 A1

FIG.12

## Procédé de fabrication d'un dispositif semi-conducteur quasi-plat susceptible d'effet laser multi-longueurs d'onde et dispositif correspondant

L'invention concerne les semi-conducteurs et plus particulièrement ceux qui sont susceptibles d'applications en optique.

Le terme semi-conducteur vise ici un semi-conducteur possédant des propriétés optiques radiatives, c'est-à-dire pour lequel le rayonnement émis par une jonction P-N excitée électriquement à une énergie supérieure à son énergie de bande interdite, est essentiellement de nature optique plutôt qu'acoustique.

La demande de brevet français n° 86 14740 décrit un procédé de fabrication d'un laser à semi-conducteur multi-longueurs d'onde. Ce laser réalisé à partir d'un empilement en double hétérostructure composée d'une alternance de couches actives de compositions différentes et de couches de confinement.

L'homme de l'art sait, d'une part, que l'on obtient, à partir d'un tel empilement, des longueurs d'ondes différentes en réalisant des jonctions P-N au voisinage de couches actives ayant un rang différent dans l'empilement.

D'autre part, ce procédé de l'art antérieur vise notamment à n'utiliser qu'une seule épitaxie multi-couches (fabrication des doubles hétérostructures en une seule fois), quel que soit le nombre de longueurs d'onde recherché. Aussi, afin de répondre à cet objectif tout en réalisant un laser multi-longueurs d'onde, le procédé du document antérieur prévoit, avant la formation des jonctions P-N, un décapage sélectif du dessus de l'empilement selon des bandes parallèles, adjacentes les unes aux autres, pour y mettre à nu des couches de confinement ayant un rang différent au moins sur deux bandes adjacentes. Les couches de confinement ainsi mises à nu définissent alors des terrasses parallèles, séparées les unes des autres par des transitions, et, au moins dans deux terrasses adjacentes, les couches actives sous-jacentes à la couche de confinement supérieure ont un rang différent, et peuvent être facilement atteintes depuis la surface des terrasses.

La formation des diverses jonctions P-N s'effectue alors par introduction d'impuretés, dans une bande incluse dans chaque terrasse, au travers d'une couche de contact étagée et ménagée à la surface libre de l'empilement.

Cette étape d'introduction d'impuretés peut se réaliser par exemple par une diffusion localisée. Pour cela, on prévoit un masque de diffusion présentant autant de fentes que de jonctions P-N souhaitées. On applique le masque sur la surface de l'empilement de sorte que chaque fente se situe au-dessus d'une terrasse, et l'on diffuse les impuretés au travers de ces fentes. On comprend alors que le profil étagé de l'empilement peut créer des problèmes quant à la bonne application du masque. En effet, si ce dernier est correctement plaqué sur la terrasse la plus élevée, le profil en gradin conduit à un espacement entre le masque et les terrasses suivantes. Cet espace augmente bien sûr avec le nombre de terrasses. Il en résulte deux inconvénients.

Le premier tient au fait qu'un masque ne "colle" pas correctement sur une surface présentant des irrégularités de forme. C'est le cas ici en raison du dénivelé de la surface libre de l'empilement.

Le deuxième concerne la précision de localisation des impuretés dans la terrasse. En effet, plus grand est l'espacement entre la fente du masque et la surface supérieure de la terrasse, plus le phénomène de diffraction à travers la fente est important, et moins bonne est la précision d'implantation des impuretés. Ceci peut conduire à une moins bonne qualité de la jonction P-N formée, ainsi qu'à une imprécision sur son positionnement.

L'invention vient d'apporter une solution plus satisfaisante à ce problème.

Un but de l'invention est de réaliser en une seule épitaxie multi-couches un laser multi-longueurs d'onde, dans lequel chaque longueur d'onde peut être excitée indépendamment, ou simultanément à l'une des autres, et dans lequel chaque jonction P-N est formée avec une précision nettement moins dépendante de sa place dans l'empilement, et ce, quel que soit le nombre de longueurs d'onde recherché.

Il a été également constaté le besoin actuel de réaliser des lasers multi-longueurs d'onde dont les différentes jonctions P-N se situent dans un même plan parallèle à la semelle du substrat. Or, les lasers multi-longueurs d'onde actuels présentent des jonctions P-N situés dans un même plan, mais incliné par rapport à la semelle du substrat, en raison de leur localisation au voisinage de couches actives de rang différent.

Un autre but de l'invention est alors de réaliser un laser multi-longueurs d'onde, remarquable en ce sens qu'il possède des jonctions P-N situées dans un même plan parallèle à la semelle du substrat bien que celles-ci se situent au voisinage de couches actives de rang différent.

Dans certaines applications optiques, il est avantageux d'effectuer un multiplexage des diverses longueurs d'onde émises par un laser multi-longueurs d'onde. On peut actuellement utiliser à cet effet, plusieurs lasers mono-longueur d'onde que l'on couple optiquement à une fibre optique multi-modes de diamètre relativement important. Un tel couplage multiplie le nombre de composants et conduit à un encombrement relativement important, alors que l'évolution actuelle de la technologie pousse à concevoir des composants intégrés de petite taille.

L'invention remédie à cette lacune en proposant de réaliser un composant monolithique permettant de coupler optiquement les diverses longueurs d'onde émises par un laser multi-longueurs d'onde à une fibre optique mono-mode, donc de diamètre moindre.

L'invention a donc pour objet un procédé de fabrication d'un dispositif semi-conducteur, en particulier d'un dispositif susceptible d'effet laser, comportant les étapes suivantes :

a) élaborer un bloc comportant un substrat supportant un empilement en double hétérostructure monocristalline comportant une alternance de couches actives de compositions différentes et de couches de confinement, toutes ces couches étant d'un même type de conductivité,

b) ménager dans l'empilement de ce bloc des rubans parallèles et allongés, contenant respectivement, au voisinage de couches actives ayant un rang différent au moins dans deux rubans voisins, des jonctions P-N, électriquement commandables individuellement et isolées les unes des autres,

c) préparer optiquement les petites extrémités opposées desdits rubans, caractérisé en ce que l'étape b) comprend l'introduction d'impuretés, d'un type de conductivité opposé à celui des couches de confinement, au travers d'une couche supérieure quasi-plane formée sur une partie au moins de la surface supérieure du bloc et présentant le même type de conductivité que lesdites impuretés ou bien une faible conductivité de type opposé.

La notion de surface "quasi-plane" s'oppose ici notamment à une surface présentant un profil étagé comme c'est le cas dans la demande de brevet français antérieure n° 86 14740.

Dans un mode de réalisation particulier, les couches actives, de type N, ont pour composition $Ga_{1-x}, Al_x As$, x différant à chaque fois, et étant inférieur à 10 % environ, tandis que les couches de confinement ont pour composition $Ga_{1-y}, Al_y As$, y étant sensiblement le même pour toutes, et égal à 30 % environ.

Les couches de la double hétérostructure sont avantageusement déposées par épitaxie, en particulier par épitaxie en phase liquide ou encore par épitaxie par jet moléculaire, ou bien par dépôt en phase vapeur de composés organo-métalliques.

Dans un mode de réalisation préféré, l'épaisseur des couches actives est de l'ordre du dixième de micromètre, tandis que celle des couches de confinement est de l'ordre du micromètre.

Dans une première variante de l'invention, l'étape a) comprend une opération de réalisation d'un substrat quasi-plan et une opération de formation d'un empilement présentant une surface libre quasi-plane constituant la surface supérieure du bloc.

Dans une deuxième variante de l'invention, l'étape a) comprend une opération de réalisation d'un substrat présentant des marches allongées, parallèles entre elles et aux rubans, et séparées les unes des autres par des transitions, ainsi qu'une opération de formation d'un empilement présentant des paliers parallèles auxdites marches ; cette étape a) comprend ensuite une opération de nivellement de l'empilement, notamment par un décapage par photogravure, antérieure à l'opération de formation de ladite couche supérieure, destinée à obtenir une surface libre de l'empilement quasi-plane, constituant la surface supérieure du bloc.

Dans un premier mode de mise en oeuvre du procédé selon l'invention, ladite couche supérieure est surajoutée, dans l'étape b), sur ladite surface supérieure quasi-plane du bloc, par un dépôt par épitaxie. L'épaisseur de cette couche supérieure est de préférence de l'ordre du dixième de micromètre et peut comprendre de l'arséniure de gallium de type P.

Dans un autre mode de mise en oeuvre du procédé selon l'invention, l'étape b) peut comprendre une opération de décapage de la surface supérieure du bloc mettant à nu au moins sur la majeure partie de la surface ainsi décapée de l'empilement, le niveau supérieur d'une couche active, celle-ci servant alors de couche de contact.

Dans l'étape b), on forme avantageusement, par introduction d'impuretés, des régions de type inversé s'étendant depuis la couche supérieure jusqu'à la couche active de rang souhaité pour former respectivement lesdites jonctions P-N.

On peut, dans l'étape b), isoler électriquement les jonctions P-N les unes des autres en réalisant un décapage localisé entre lesdites régions de type inversé, par voie sèche ou humide, de façon à graver des sillons s'étendant depuis ladite couche supérieure jusqu'au moins au-delà de chaque jonction P-N située de part et d'autre du sillon correspondant, ce qui permet de ménager ainsi les rubans.

On peut également isoler électriquement lesdites jonctions P-N en réalisant une implantation protonique entre lesdites régions de type inversé de façon à ménager ainsi lesdits rubans.

Il est également procédé, dans l'étape b), à un dépôt métallique de contact individuel sur chaque région de type inversé et à un dépôt métallique de contact commun sur le substrat.

Après préparation optique des petites extrémités opposées des rubans, notamment par usinage par voie humide ou sèche ou bien par clivage, on obtient, à l'aide de la première variante du procédé selon l'invention un dispositif semi-conducteur dont la surface supérieure, c'est-à-dire la surface opposée à la semelle du substrat, est quasi-plane mais dans laquelle les jonctions P-N formées ne sont pas situées dans un plan parallèle à cette semelle mais peuvent être situées dans un plan incliné si l'on forme les jonctions P-N au voisinage de couches actives de rang différant d'une unité à chaque fois.

On obtient, en utilisant la deuxième variante du procédé selon l'invention, un dispositif semiconducteur dont la surface supérieure est également quasi-plane mais dont les jonctions P-N sont cette fois-ci situées dans un même plan parallèle à la semelle du substrat.

Dans une troisième variante du procédé selon l'invention, l'opération de réalisation du substrat comprend, outre la formation de marches allongées séparées les unes des autres par des transitions, la formation d'une contre-marche transversale s'étendant dans un plan sensiblement perpendiculaire aux marches et à chaque transition et définissant sur ce substrat des fonds supérieur et inférieur pour ledit empilement ; dans cette variante, le procédé selon l'invention comprend alors une étape supplémentaire de réalisation, au sein de l'empilement, au moins dans le secteur supporté par le fond supérieur, d'une couche transparente formant guide de lumière pour les émissions lumineuses émises par les jonctions P-N.

On obtient alors un composant monolithique comprenant d'une part une structure semi-conductrice, susceptible d'effet laser multi-longueurs d'onde, et d'autre part un guide de lumière pour les diverses longueurs d'onde émises par cette structure et susceptible d'être raccordé à une fibre optique mono-mode.

L'invention a également pour objet un dispositif semi-conducteur, comprenant sur un substrat, au moins deux empilements de double hétérostructure comportant chacun au moins une couche active encadrée par deux couches de confinement, ces deux empilements étant en forme de rubans allongés disposés côte-à-côte, électriquement isolés l'un de l'autre, comportant chacun une jonction P-N, électriquement commandable individuellement et située au voisinage d'une couche active de composition différente pour les deux empilements, les petites extrémités opposées de ces rubans étant préparées optiquement, caractérisé en ce que la surface supérieure du dispositif, opposée à la semelle du substrat, est quasi-plane.

La notion "quasi-plane" s'applique ici quel que soit le mode d'isolement des rubans, car les surfaces supérieures des deux empilements sont sensiblement au même niveau. Dans un premier mode de réalisation, chaque empilement comprend le même nombre de couches. Dans un second mode de réalisation, chaque empilement comprend un nombre différent de couches et le substrat présente alors des marches allongées, parallèles entre elles et aux rubans, et séparées les unes des autres par des transitions.

Dans un troisième mode de réalisation, le substrat comporte en outre une contre-marche transversale s'étendant dans un plan sensiblement perpendiculaire aux marches et à chaque transition et définissant sur ce substrat des fonds inférieur et supérieur pour ledit empilement et comportant, au moins dans le secteur supporté par le fond supérieur, une couche transparente formant guide de lumière pour les émissions lumineuses émises par les jonctions P-N.

D'autres avantages et caractéristiques de l'invention apparaîtront à l'examen de la description détaillée ci-après et des dessins annexés sur lesquels :

- les figures 1 à 6 illustrent les étapes successives d'une première variante du procédé selon l'invention, aboutissant à l'obtention d'une structure semi-conductrice quasi-plate dans laquelle les jonctions P-N formées sont situées dans un même plan incliné par rapport à la semelle du substrat ;

- Les figures 7 à 12 illustrent les étapes successives d'une deuxième variante du procédé selon l'invention conduisant à l'obtention d'une structure semi-conductrice quasi-plate dans laquelle les diverses jonctions P-N formées sont situées dans un même plan parallèle à la semelle du substrat ;

- la figure 13 illustre une étape de formation d'un substrat dans une troisième variante du procédé selon l'invention ;

- les figures 14 et 15 illustrent deux étapes de la troisième variante du procédé selon l'invention ; et

- la figure 16 illustre un dispositif semiconducteur obtenu par cette troisième variante.

Les dessins comportent, pour l'essentiel, des éléments de caractère certain. A ce titre, ils font partie intégrante de la description et pourront non seulement servir à mieux faire comprendre la description détaillée ci-après mais aussi contribuer à la définition de l'invention, le cas échéant.

D'une façon générale, les références des différents éléments décrits seront affectés respectivement des suffixes 1, 2, 3, selon qu'il s'agit de la première, de la deuxième ou de la troisième variante du procédé. De plus, les références de ces différents éléments comprennent un groupe de lettres (par exemple couche active : CA). Cependant, puisque l'invention concerne la fabrication d'un dispositif susceptible d'effet laser multi-longueurs d'onde, il existe, dans chaque variante de l'invention, plusieurs éléments ayant des fonctions analogues. Dans ce cas, ceux-ci sont désignés génériquement par le groupe de lettres correspondant suivi d'un ou de deux nombres i, j (par exemple couches actives : CAi). Ces nombres seront précisés chaque fois que nécessaire pour référencer un élément bien particulier. Enfin, les différents suffixes 1, 2, 3 des références seront supprimés dans la description lorsqu'il s'agira d'évoquer des éléments ou des étapes communs aux trois variantes.

On va maintenant décrire des caractéristiques communes aux différentes variantes du procédé selon l'invention.

D'une manière générale, les matériaux utilisés, pour la double hétérostructure comprennent un alliage III-V. Le substrat S peut également comprendre un alliage III-V ou bien du silicium.

De tels semi-conducteurs, qui sont en général de structure monocristalline, sauf mention contraire, sont actuellement obtenus à partir des matériaux dits "alliages III-V", c'est-à-dire réunissant au moins un élément de la colonne III et au moins un élément de la colonne V de la Classification périodique de Mandeldeev. En fait, il s'agit des colonnes IIIA et VA, dans la version actuelle de cette Classification. Plus précisément encore, on considère d'une part l'aluminium, le gallium et l'indium, d'autre part le phosphore, l'arsenic et l'antimoine.

De manière connue, ces matériaux peuvent avoir ou se voir conférer une conductivité de type N ou bien de type P, en recevant des impuretés appropriées. La conductivité initiale des alliages III-V est due à leur propriété semi-conductrice intrinsèque, ainsi qu'aux impuretés résiduelles dues à leur procédé de fabrication. En ce qui concerne le type de conductivité acquis, on citera par exemple le zinc, le cadmium, le magnésium et le béryllium qui sont susceptibles de conférer le type P à de l'arséniure de gallium dont la conductivité initiale est de type N.

Dans la suite de la présente description, on se limitera aux cas dits "système Ga As", dans lequel le semi-conducteur de base est de l'arséniure de gallium.

Dans cette hypothèse, le substrat S peut être constitué uniquement d'arséniure de gallium, de type N+, c'est-à-dire manifestant une forte conductivité de type N. Il peut être également constitué en grande majorité d'arséniure de gallium de type N mais alors, ainsi qu'il sera expliqué en l'état ici après, il est nécessaire qu'il comprenne en surface une couche d'arséniure de gallium de type N+.

La double hétérostructure va être réalisée par épitaxie sur ce substrat, en empilant différentes couches. Différentes techniques d'épitaxie sont connues. On utilisera l'épitaxie en phase liquide (LPE pour Liquid Phase Epitaxy) ou le dépôt en phase vapeur à partir de composés organiques métalliques (MOCVD, pour Metallo Organic Chemical Vapour Deposition), ou encore l'épitaxie par jet moléculaire (MBE pour Molecular Beam Epitaxy).

Dans un mode de mise en oeuvre particulier, les couches de confinement CCi sont toutes en matériau de type N, de formule générale :
$Ga_{1-y} Al_y$ As, c'est-à-dire qu'il s'agit d'un alliage arséniure d'aluminium-gallium, où la proportion d'aluminium est y et celle de gallium 1-y. Typiquement, y est de l'ordre de 30 % et l'épaisseur des couches de confinement CCi est d'environ 1 micromètre.

Après l'épitaxie de la première couche de confinement CC1 sur le substrat S, on procède à l'épitaxie de la première couche active CA1 dont la composition est par exemple :
$Ga_{1-x_1} Al_{x_1}$ As, c'est-à-dire qu'il s'agit d'un alliage d'arséniure de gallium-aluminium, où la proportion des atomes d'aluminium est $x_1$, tandis que celle de gallium est $1-x_1$. L'épaisseur de la couche active est typiquement de l'ordre de 0,15 micromètre. La proportion d'atomes d'aluminium est choisie entre 0 et 10 %, suivant la longueur d'onde désirée.

Ensuite, une seconde couche de confinement CC2 est épitaxiée sur la première couche active CA1.

On procède alors à l'épitaxie de la seconde couche active CA2, dont l'épaisseur est à nouveau d'envion 0,15 micromètre, mais la proportion $x_2$ d'aluminium et de gallium est différente.

Une troisième couche de confinement CC3 est alors réalisée puis une troisième couche active CA3, avec une proportion $x_3$, et enfin une dernière couche de confinement CC4, qui termine l'empilement en double hétérostructure.

Bien entendu, le nombre de couches de confinement et de couches actives peut être plus ou moins important, suivant le nombre de fréquences différentes que l'on souhaitera pouvoir exciter dans les dispositifs laser. L'invention suppose qu'il existe deux couches actives différentes empilées, au moins.

On supposera également que la surface supérieure SS du bloc BL ainsi élaboré (étape a)) est quasi-plane. On rappelle ici que la notion de surface quasi-plane s'oppose à celle d'une surface présentant notamment des terrasses comme c'est le cas dans la demande de brevet français n° 86 14740.

L'étape b) du procédé consiste ensuite à ménager dans l'empilement de ce bloc des rubans parallèles et allongés RUBi, contenant respectivement, au voisinage de couches actives ayant un rang différent au moins dans deux rubans voisins, des jonctions P-N, Ji, électriquement commandables individuellement et isolées les unes des autres.

Dans cette étape b), on forme, sur une partie au moins de la surface supérieure quasi-plane SS du bloc BL, une couche supérieure quasi-plane CS qui est, par exemple, formée d'un semi-conducteur monocristallin III-V d'un type de conductivité opposé à celui de la double hétérostructure. Le plus simple est de réaliser cette couche supérieure en arséniure de gallium de type P, par épitaxie, d'une épaisseur d'environ 0,15 micromètre.

Une fois que cette couche supérieure est formée, on introduit au travers de celle-ci des impuretés d'un type de conductivité opposé à celui des couches de confinement et présentant, dans le cas d'une couche supérieure telle que celle décrite ci-avant, le même type de conductivité que cette couche supérieure, c'est-à-dire de type P.

On forme ainsi des régions de type inversé Ri s'étendant depuis la couche supérieure jusqu'à la couche active de rang souhaité pour former les jonctions P-N du dispositif semi-conducteur.

Cette introduction d'impuretés peut se faire notamment soit par diffusion, soit par implantation ionique suivie de recuit. On reviendra en détail ci-après sur cette opération d'introduction mais on peut d'ores et déjà indiquer que, dans le cas d'impuretés pris dans le groupe évoqué ci-dessus, le zinc et le cadmium sont susceptibles d'être amenés par diffusion ou par implantation ionique alors qu'en principe, le bérylium, le manganèse ne sont amenés que par implantation ionique, lorsqu'il s'agit de construire une région de type inversé bien limitée.

On dépose ensuite un dépôt métallique de contact individuel DMIi sur chaque région de type inversé Ri (par exemple un alliage or-zinc (Zn,Au)) et un dépôt métallique de contact commun DMS sur le substrat S (par exemple un alliage or-germanium (Au,Ge)). Ce dépôt métallique de contact commun peut être déposé sous la semelle du substrat si celui-ci est constitué d'arséniure de gallium de type N+ ou bien alors au contact de la couche supérieure fortement dopée N+ de ce substrat si elle est présente.

Il convient également d'isoler électriquement les jonctions P-N les unes des autres.

Cette opération peut être réalisée en gravant des sillons Vij s'étendant depuis la couche supérieure CS jusqu'au moins au-delà de chaque jonction P-N, Ji, située de part et d'autre du sillon correspondant, ce qui permet de ménager ainsi lesdits rubans RUBi. De préférence, on gravera ces sillons depuis la couche supérieure jusqu'au substrat S.

Ces sillons peuvent être obtenus à l'aide d'un décapage localisé par voie humide, c'est-à-dire par simple attaque chimique, ou bien par voie sèche, à savoir :

- gravure ionique réactive (RIE, pour Reactive Ion Etching) ;
- gravure réactive par faisceau d'ions (RIBE, pour Reactive Ion Beam Etching) ;
- gravure ionique excitée par magnétron (MIE, pour Magnetron Ion Etching) ;
- usinage ionique classique (UI); ou
- usinage par faisceau d'ions focalisés (F.I.B.).

Selon une autre variante de l'invention, l'isolation électrique entre les différentes jonctions P-N peut être réalisée par une implantation protonique au lieu de constituer des sillons.

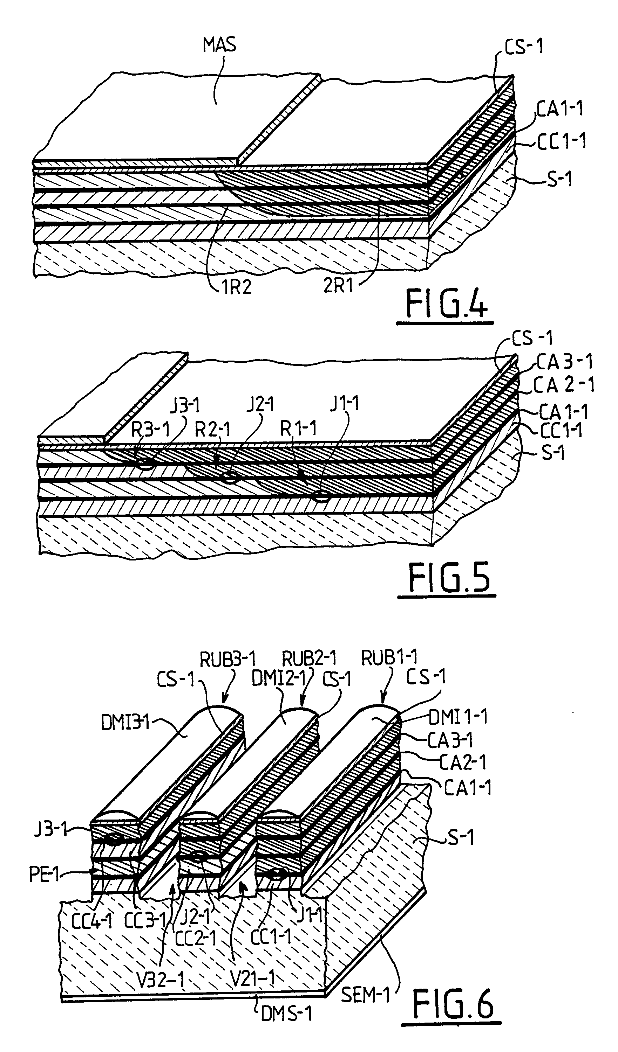

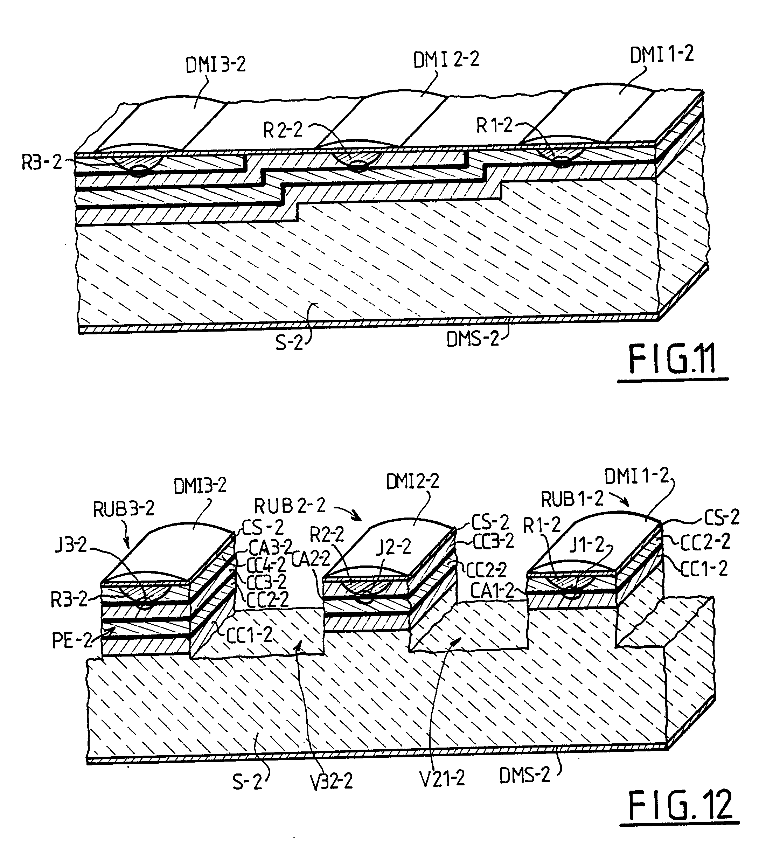

Pour manifester l'effet laser, il est nécessaire de préparer optiquement les petites extrémités opposées PEi des rubans RUBi ainsi ménagées (figures 6 et 12), c'est-à-dire celles que l'on voit en coupe sur ces figures et l'extrémité opposée.

Cette préparation peut être effectuée de manière connue par clivage ou encore par usinage par voie humide ou voie sèche.

Le dispositif semi-conducteur ainsi obtenu est susceptible d'un effet laser et ce, avec une longueur d'onde différente pour chacune des jonctions P-N formées, dans la mesure où la couche active, au voisinage de laquelle est formée cette jonction P-N, n'a pas la même composition pour ces différentes régions. On peut alors émettre sélectivement différentes longueurs d'onde à l'aide d'un tel dispositif et ce, d'une manière qui peut être commandée indépendamment.

Dans la mesure où l'on aura voulu préparer plusieurs dispositifs semi-conducteurs lasers multi-longueurs d'onde sur un même substrat semi-conducteur, le procédé de fabrication comprendra bien sûr une étape supplémentaire, pour la séparation du dispositif semi-conducteur en puces individuelles comprenant chacune au moins deux rubans adjacents.

Le dispositif semi-conducteur terminal comprend alors sur un substrat S au moins deux empilements de double hétérostructure comportant chacun au moins une couche active CA encadrée par deux couches de confinement CCi,CCj, ces deux empilements étant en forme de rubans allongés RUBi, disposés côte-à-côte, électriquement isolés l'un de l'autre, comportant chacun une jonction P-N, Ji, électriquement commandable individuellement et située au voisinage d'une couche active de composition différente pour les deux empilements. Les petites extrémités opposées de ces rubans sont préparées optiquement. Ce dispositif semi-conducteur est remarquable en ce sens que sa surface supérieure, c'est-à-dire sa surface opposée à la semelle SEM du substrat S est quasi-plane. Ainsi qu'il a été expliqué ci-avant, le caractère quasi-plan de la surface est justifié, quel que soit le mode d'isolement électrique des jonctions P-N, car les surfaces libres des empilements sont sensiblement au même niveau, par opposition notamment à des niveaux étagés.

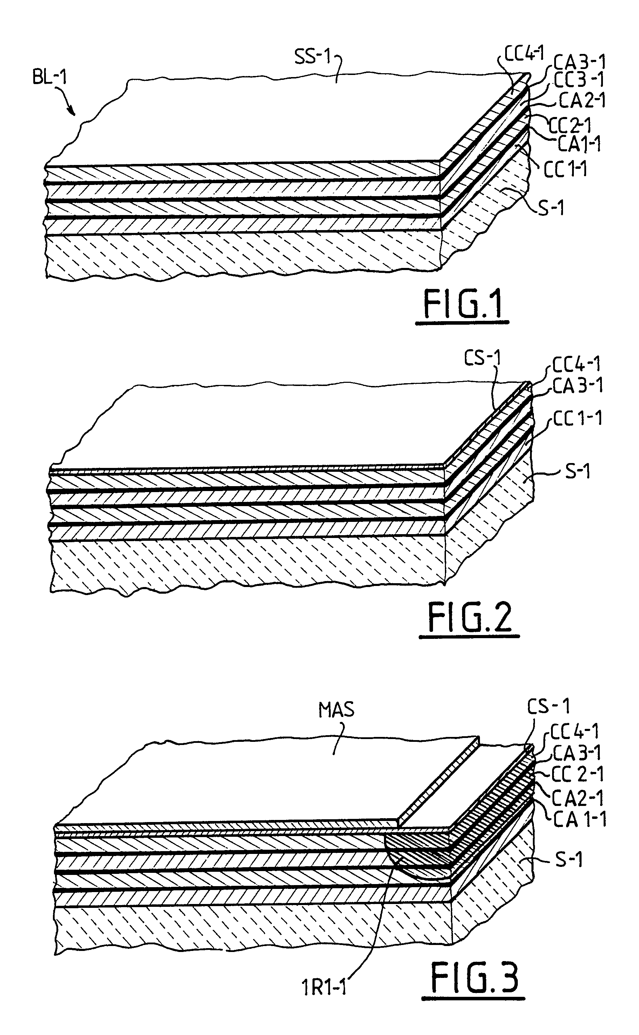

On se réfère maintenant plus particulièrement aux figures 1 à 6 pour décrire la première variante du procédé selon l'invention.

Sur la figure 1, on part d'un substrat S-1 quasi-plan, en arséniure de gallium de type N + .

L'empilement de double hétérostructure formée sur ce substrat présente alors une surface libre quasi-plane, ce qui permet donc d'élaborer un bloc BL-1 possédant une surface supérieure SS-1 quasi-plane.

On peut alors procéder (figure 2) au dépôt de la couche supérieure CS-1.

Il convient de remarquer ici qu'en variante, cette opération de formation de la couche supérieure pourrait comprendre une opération de décapage de la surface supérieure du bloc mettant à nu la couche active CA3-1 de façon que cette dernière serve de couche supérieure. Ceci serait possible car, alors, la couche supérieure présenterait une faible conductivité de type opposé à celui des impuretés, en raison de la composition même de cette couche active.

Les figures 3, 4 et 5 illustrent l'opération d'introduction d'impuretés au travers de la couche supérieure CS-1 par diffusion. L'homme de l'art comprend aisément que cette opération est facilitée par le caractère quasi-plan de cette couche supérieure, ce qui permet de plaquer correctement le masque de diffusion MAS sur cette couche supérieure.

On supposera ici que les diffusions s'effectuent en ampoule scellée à environ 640° C (Celsius) à partir d'une source de diffusion d'arséniure de zinc $(ZnAs_2)$.

Dans une première phase (figure 3), le masque MAS cache la majeure partie de la couche supérieure CS-1. On effectue alors une diffusion pendant environ 60 minutes, de façon à obtenir une première région diffusée 1R1-1 dont la partie inférieure se situe entre la première couche active CA1-1 et la deuxième couche active CA2-1.

Dans une deuxième phase (figure 4), le masque est décalé vers la gauche de façon à découvrir une plus grande partie de la couche supérieure CS-1. On effectue alors une diffusion pendant un temps de 45 minutes environ. La région 1R1-1 devient une région 2R1-1 plus large et dont la limite inférieure se situe plus près de la première couche active CA1-1. On obtient également une deuxième région diffusée 1R2-1 dont la limite inférieure se situe entre la deuxième et la troisième couche active.

Enfin, au cours d'une troisième étape de diffusion (figure 5) qui dure 15 minutes environ, les deux régions diffusées de la figure 4 atteignent respectivement la couche active de rang souhaité de façon à former deux régions de type inversé R1-1 et R2-1. Ces régions R1-1 et R2-1 constituent respectivement des jonctions P-N, J1-1 et J2-1 avec les couches actives CA1-1 et CA2-1. Il s'est également formé, au cours de cette troisième étape de diffusion, une région de type inversé R3-1 qui constitue avec la troisième couche active CA3-1 une troisième jonction P-N, J3-1.

Ces jonctions Ji-1 sont illustrées sur la figure 5 bien qu'elles ne soient pas en pratique repérables optiquement.

L'homme de l'art comprend aisément que chaque diffusion influe sur les régions diffusées lors des précédentes diffusions et qu'il s'agit donc en conséquence d'ajuster avec précision les temps de diffusion pour atteindre à la fin les jonctions P-N au niveau des couches actives de rang souhaité.

On remarque également sur la figure 5 que les trois régions de type inversé Ri-1 forment une zone continue unique. On aurait pu cependant concevoir que ces régions soient formées par des diffusions localisées, c'est-à-dire en utilisant un masque muni de fentes pour ne diffuser des impuretés que dans des bandes bien précises à l'intérieur de l'empilement.

Le dispositif semi-conducteur finalement obtenu est illustré sur la figure 6. Le contact métallique commun DMS-1 est fixé sur la semelle SEM-1 du substrat car celui-ci est composé d'arséniure de gallium de type N + . Chaque empilement comprend le même nombre de couches et l'on remarque que les trois jonctions P-N, Ji-1, sont situées dans un même plan incliné par rapport à la semelle du substrat.

Les rubans ainsi ménagés ont une largeur d'environ 5 micromètres, une longueur d'environ 300 micromètres et les sillons ont une largeur d'environ 20 micromètres.

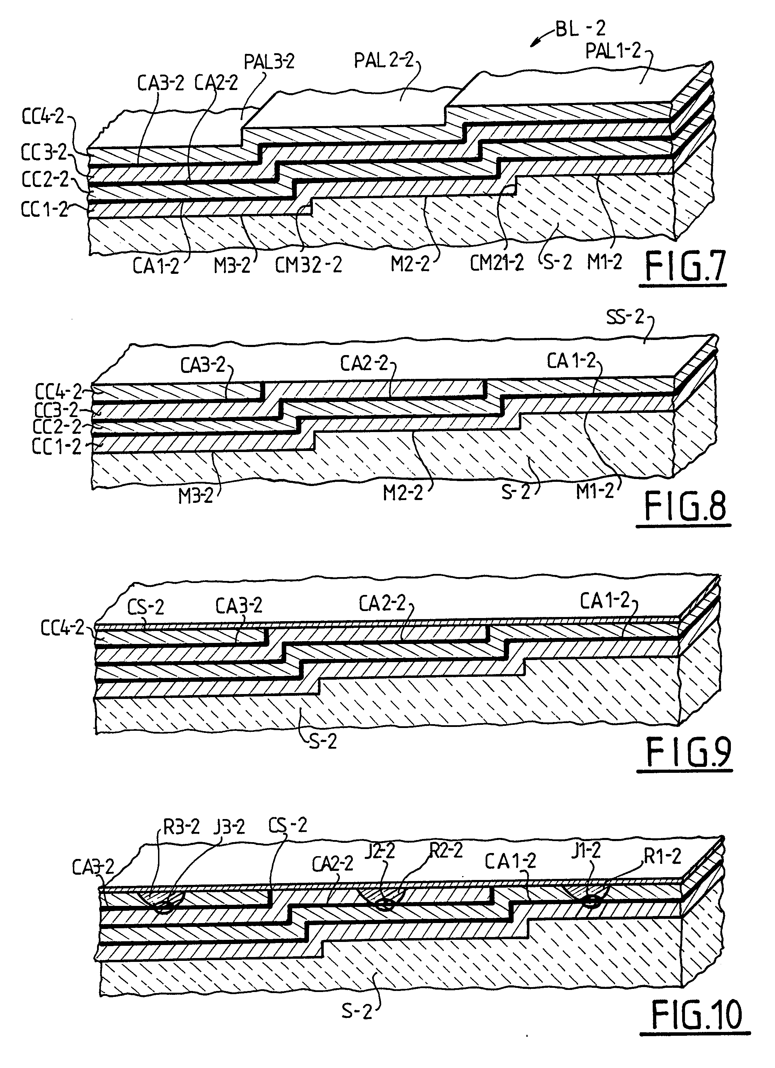

On se réfère maintenant plus particulièrement aux figures 7 à 12 pour illustrer la seconde variante du procédé selon l'invention.

On suppose toujours ici que le substrat S-2 est de l'arséniure de gallium de type N + . On remarque que ce substrat S-2 présente des marches allongées Mi-2, parallèles entre elles, d'une largeur d'environ 20 micromètres et séparées les unes des autres par des transitions CMij-2 d'une hauteur d'environ 1 micromètre. On a illustré ici trois marches M1-2, M2-2, M3-2, séparées par respectivement deux transitions CM21-2 et CM32-3.

L'empilement alors formé sur ce substrat, et comportant trois couches actives et quatre couches de confinement, présente une surface libre ayant des paliers PAL1-2, PAL2-2, PAL3-2, parallèles auxdites marches.

La surface libre de cet empilement n'étant pas quasi-plane, il convient de procéder à un nivellement de celui-ci (figure 8). Cette opération de nivellement consiste à décaper, notamment par photogravure, successivement les différents paliers du bloc BL-2. On obtient alors successivement, depuis le substrat S-2 jusqu'à la surface supérieure SS-2 du bloc BL-2 :

- sur la marche M1-2 : la couche de confinement CC1-2, la première couche active CA1-2, la deuxième couche de confinement CC2-2 ;

- sur une majeure partie de la marche M2-2 : la première couche de confinement CC1-2, la première couche active, la deuxième couche de confinement, la deuxième couche active CA2-2, la troisième couche de confinement CC3-2 ;

- sur la majeure partie de la marche M3-2 : la première couche de confinement, la première couche active, la deuxième couche de confinement, la deuxième couche active, la troisième couche de confinement, la troisième couche active CA3-2, et enfin la quatrième couche de confinement CC4-2.

Les couches de confinement supérieures sont séparées par les transitions verticales des différentes couches actives. Ces régions intermédiaires peuvent présenter certaines irrégularités quant à leur forme mais ne sont pas d'une grande importance, car comme on le verra ci-après, elles seront inhibées lors de l'isolement électrique des différentes jonctions P-N.

La surface supérieure du bloc étant quasi-plane, il convient de procéder maintenant au dépôt de la couche supérieure CS-2 (figure 9). En variante, on pourrait concevoir que l'opération de formation de cette couche supérieure compren ne une opération de décapage de la surface libre de l'empilement conduisant également à une surface supérieure quasi-plane mais mettant à nu au moins sur la majeure partie de la surface ainsi décapée, le niveau supérieur d'une couche active, celle-ci servant alors de couche de contact. Ainsi, dans le cas présent, on aurait pu concevoir que cette opération de décapage mette à nu sur la marche M1-2 la deuxième couche active CA2-2, sur la marche M2-2, la troisième couche active CA3-2 et sur la marche M3-2, une quatrième couche active (non représentée ici). Ces couches actives ainsi mises à nues serviraient de couches de contact et seraient séparées par des bandes de couches de confinement. Cette couche de contact présenterait alors une faible conductivité de type opposé aux impuretés introduites, de par la nature même de sa composition.

La surface supérieure CS-2 étant quasi-plane, l'étape d'introduction des impuretés, notamment par diffusion, est particulièrement aisée car le masque plaque correctement sur cette couche supérieure. Il est de plus seulement nécessaire ici de n'effectuer qu'une seule étape de diffusion pour former en une seule fois toutes les régions de type inversé R1-2, R2-2, R3-2 (figure 10).

L'homme de l'art remarquera que l'on a supposé ici que ces diffusions étaient localisées dans une bande étroite. On pourrait cependant concevoir qu'elle s'effectue globalement à travers toute la surface de la couche supérieure de façon à obtenir une zone continue unique de type inversé.

Dans le cas présent, pour une diffusion en ampoule scellée avec une source de diffusion d'arséniure de zinc (ZnAs2), le temps de diffusion nécessaire pour former les régions de type inversé est de 15 minutes environ à une température de 640°C.

Il se forme alors au voisinage de couches actives ayant un rang différent, des jonctions P-N, Ji-2, qui sont représentées sur cette figure 10 bien qu'elles ne soient pas repérables optiquement.

Sur la figure 11, on a représenté le dépôt de contact individuel DMIi-2 sur chaque région de type inversé et un dépôt métallique de contact commun DMS-2 sur la semelle du substrat S-2 car celui-ci est en arséniure de gallium de type N +.

Après isolement électrique des jonctions PN, notamment par les sillons V32-2 et V21-2, on obtient le dispositif semi-conducteur de la figure 12.

Ce dispositif semi-conducteur quasi-plat, c'est-à-dire présentant une surface supérieure, opposée à la semelle du substrat, quasi-plane, est remarquable en ce sens que chaque empilement de double hétérostructure comprend un nombre différent de couches. Ainsi, les jonctions P-N sont situées non seulement dans un même plan mais encore parallèlement à la semelle du substrat.

Les rubans ainsi ménagés ont une largeur d'environ 15 micromètres, une longueur d'environ 250 micromètres et les sillons ont une largeur d'environ 5 micromètres.

Dans le cas où l'on aurait effectué une diffusion globale à travers toute la surface de la couche supérieure, les rubans auraient eu une largeur d'environ 5 micromètres tan dis que la largeur des sillons aurait été de l'ordre de 15 micromètres..

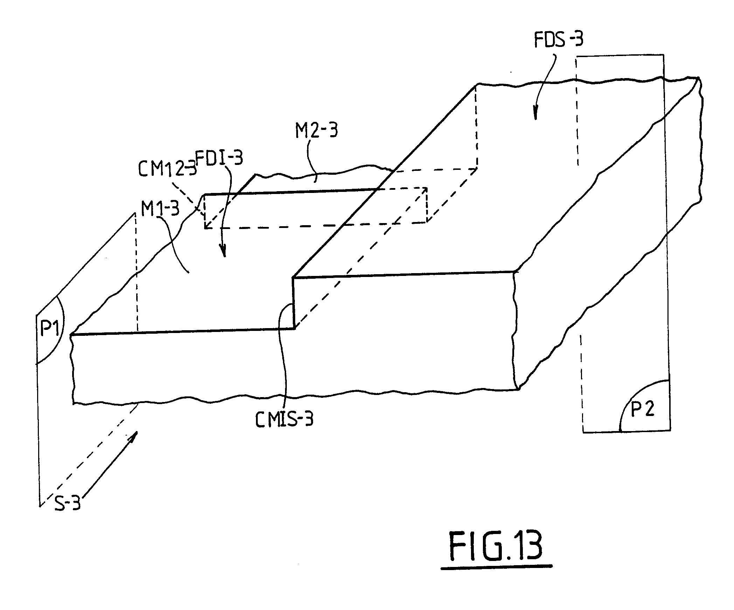

On se réfère maintenant plus particulièrement aux figures 13 à 16 pour illustrer une troisième variante du procédé selon l'invention.

Comme on le voit sur la figure 13, le substrat utilisé pour cette variante présente une partie analogue à celle utilisée pour la variante précédente, c'est-à-dire qu'il présente des marches allongées Mi-3 parallèles entre elles et séparées les unes des autres par des transitions CMij-3. On supposera ici qu'il ne présente que deux marches allongées M1-3 et M2-3 séparées par une transition CM12-3.

L'opération de réalisation du substrat S-3 comprend ici en outre la formation d'une contre-marche transversale CMIS-3, s'étendant dans un plan sensiblement perpendiculaire à la transition CM12-3 et définissant sur ce substrat des fonds inférieur FDI-3 et supérieur FDS-3. Cette contre-marche transversale a une hauteur de 1,5 micromètre par rapport à la marche M1-3 et une hauteur de 2,5 micromètres par rapport à la marche M2-3.

On définit, sur cet empilement, un plan P1 parallèle à la contre-marche transversale et perpendiculaire aux marches allongées ainsi qu'un deuxième plan P2 perpendiculaire au plan P1.

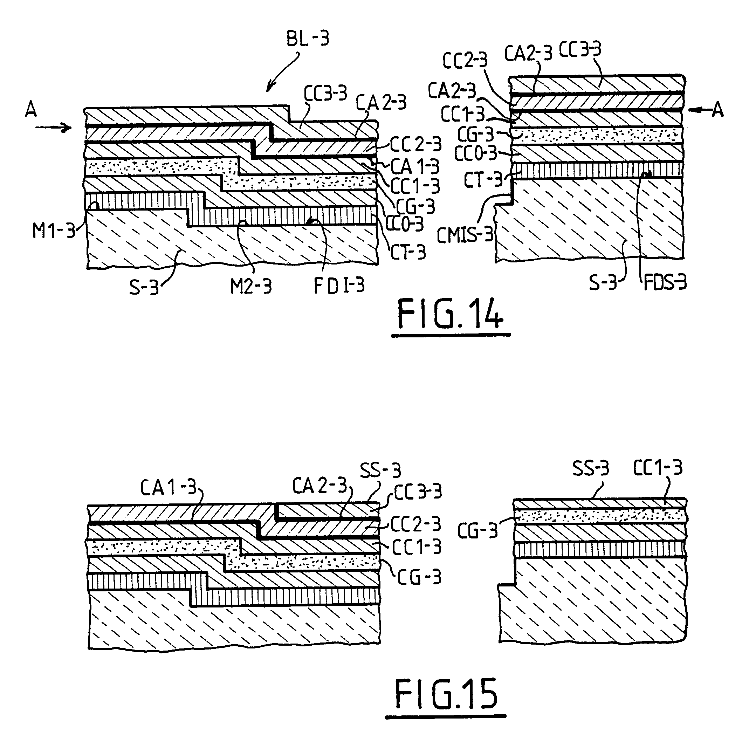

La figure 14 illustre un empilement formé dans cette variante. La partie gauche représente une coupe de cet empilement dans le plan P1 et la partie droite une coupe dans le plan P2.

Le substrat est ici de l'arséniure de gallium de type semi-isolant. Il convient alors dans ce cas de déposer une couche tampon CT d'arséniure de gallium de type N+ sur la surface supérieure de ce substrat. Cette couche a une épaisseur d'environ 1 micromètre et est déposée par épitaxie sur la surface supérieure du substrat. On désignera cependant abusivement par substrat, l'ensemble constitué par l'arséniure de gallium de type semi-isolant et la couche tampon de type N+.

Par rapport à la variante précédente, celle-ci comporte une étape supplémentaire de dépôt au sein de l'empilement d'une couche transparente qui forme guide de lumière pour les émissions lumineuses émises par les différentes jonctions P-N réalisées.

Ainsi, en une seule épitaxie multi-couches, on dépose successivement une première couche de confinement CC0-3 d'une épaisseur d'un micromètre environ, puis une couche transparente CG-3 de composition $Al_{0,2} Ga_{0,8} As$ d'une épaisseur d'environ 1 micromètre, puis une autre couche de confinement CC1-3 d'une épaisseur d'un micromètre environ, puis successivement une première couche active CA1-3, une couche de confinement CC2-3, une deuxième couche active CA2-3 et enfin une dernière couche de confinement CC3-3. On remarque alors que la couche transparente CG-3 est encadrée par deux couches de confinement CC0-3 et CC1-3. Son indice de réfraction est supérieur aux indices de réfraction des deux couches de confinement qui l'encadrent et la hauteur de la contre-marche transversale CMIS-3 est sensiblement égale à la distance séparant, dans le secteur supporté par le fond inférieur FDI-3, le plan médian de la couche transparente CG-3, du plan moyen de la couche active CA1-3 dans sa zone supportée par la marche inférieure M2-3.

L'opération de nivellement de cet empilement s'effectue alors suivant les flèches A et conduit à un bloc présentant une surface supérieure quasi-plane SS-3 (figure 15). La partie gauche de cette figure 15, qui correspond à la partie gauche de la figure 14, présente une structure de même type que celle décrite dans la variante précédente, et la partie droite de cette figure 15, qui correspond à la partie droite de la figure 14, montre sur la couche tampon CT la couche de confinement CC0-3 puis la couche transparente CG-3 et enfin une partie de la couche de confinement CC1-3.

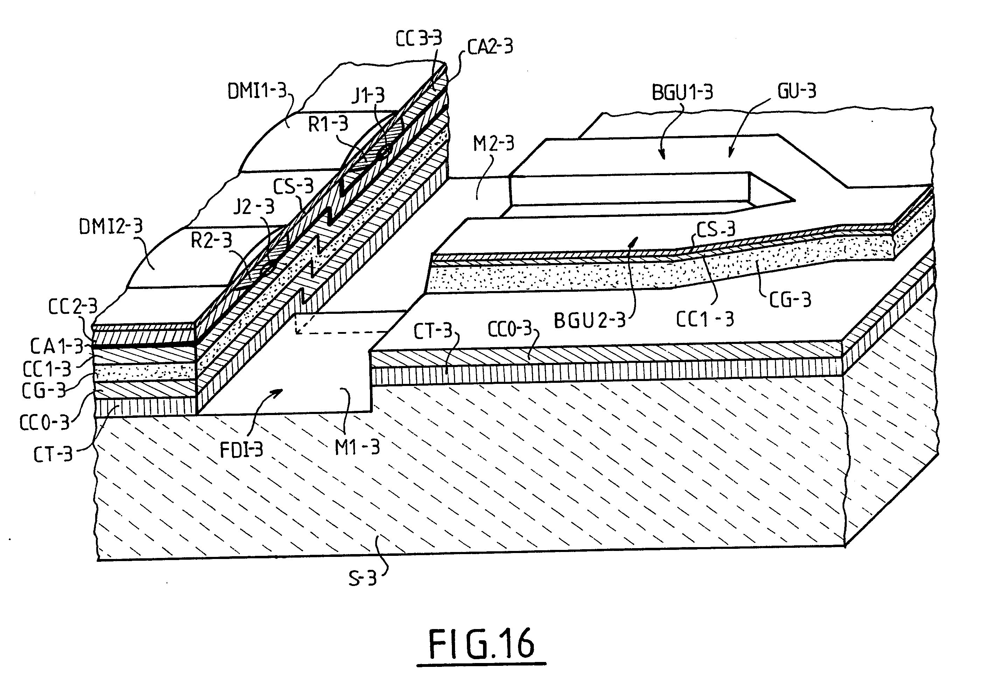

Les étapes suivantes de réalisation de la structure laser proprement dite sont identiques à celles décrites dans la variante précédente. Le dépôt de contact commun est cette fois-ci déposée sur la couche tampon CT et n'est pas représenté sur la figure 16.

En ce qui concerne l'élaboration de la partie guide proprement dite, on peut concevoir que la formation de la couche supérieure CS-3 s'effectue, après nivellement selon les flèches A, également sur la partie de cette surface supérieure du bloc supportée par le fond supérieur, bien que ceci ne soit pas absolument nécessaire.

L'opération suivante consiste alors à former, au sein de la couche transparente CG-3 deux branches BGU1-3 et BGU2-3, séparées l'une de l'autre, et possédant chacune une première extrémité située en regard d'une jonction P-N (respectivement J1-3, J2-3) et réunies à leurs extrémités opposées respectives pour se prolonger par un tronçon unique TRO-3.

Cette opération de formation peut s'effectuer de façon connue par un décapage par photogravure.

Chaque branche BGUi-3 comprend donc, sur la couche de confinement CCO-3, la couche guide CG-3 surmontée d'une épaisseur résiduelle de couche de confinement CC1-3, et éventuellement surmontée de la couche supérieure CS-3. Dans ce cas le confinement de la lumière est dû à la variation d'indice entre d'une part la couche guide CG-3 et la couche de confinement inférieure CCO-3, et d'autre part, entre la couche guide CG-3 et la couche de confinement supérieure CC1-3. On notera également que la couche CG-3 apparaît sur la tranche du guide.

La structure laser proprement dite et la partie guide peuvent être séparées par un canal perpendiculaire aux rubans laser ou bien se rejoindre mutuellement par une zone quasi-verticale épousant la forme de la contre-marche transversale du substrat. Dans le cas d'une séparation par un canal, celui-ci est réalisé, au voisinage de la contre-marche transversale, soit dans la partie laser soit dans la partie guide, par une attaque chimique du type de celles évoquées ci-avant.

Le guide GU-3 ainsi formé a donc une forme de Y et permet le raccord, par l'intermédiaire du tronçon TRO-3 à une fibre optique monomode. Bien entendu, dans le cas où il conviendrait de guider un nombre d'émissions lumineuses supérieures à deux, le guide GU contiendrait autant de branches que de jonctions P-N.

Le dispositif semi-conducteur ainsi obtenu (figure 16) est un composant monolithique comprenant d'une part une structure susceptible d'effet laser et d'autre part une couche transparente formant guide de lumière pour les émissions lumineuses émises par les jonctions P-N. Le plan médian de cette couche lumineuse est alors sensiblement le même que le plan moyen contenant les jonctions P-N.

La partie supérieure du guide GU-3 se situe donc sensiblement au même niveau que la partie supérieure de la partie laser proprement dite, ce qui permet de considérer ce composant comme quasi-plat.

D'autres modes d'élaboration de la partie guide sont possibles.

Ainsi est-il envisageable de décaper toutes les couches supportées par la couche guide CG-3, puis de ménager les branches du guide dans cette couche CG-3. Le confinement de la lumière est alors dû à la variation d'indice entre, d'une part la couche guide CG-3 et la couche de confinement inférieure CCO-3, et, d'autre part, entre la couche guide CG-3 et l'air.

Il est aussi envisageable de matérialiser la forme du guide en formant les deux branches et le tronçon unique dans la couche de confinement supérieure CC1-3, éventuellement surmontée de la couche supérieure CS-3; la couche guide CG3, dans laquelle vont se propager les émissions lumineuses, n'est alors pas décapée partiellement et reste entière et plane.

L'invention n'est pas limitée aux modes de réalisation ci-dessus décrits mais en embrasse toutes les variantes, notamment la suivante :
- on peut par exemple réaliser le dispositif semiconducteur multi-longueurs d'onde non seulement dans le système Ga As mais aussi dans le système InP (phosphure d'indium), avec des alliages convenables ou encore sur tout autre matériau semi-conducteur doué de propriétés optiques radiatives.

Bien entendu certains des moyens décrits ci-dessus peuvent être omis dans les variantes où ils ne servent pas. De plus, il convient de remarquer que la première variante de l'invention (figures 1 à 6) pourrait être considérée indépendamment des deux autres.

## Revendications

1. - Procédé de fabrication d'un dispositif semiconducteur, en particulier d'un dispositif susceptible d'effet laser, comportant les étapes suivantes :

a) élaborer un bloc (BL) comportant un substrat (S) supportant un empilement en double hétérostructure monocristalline comportant une alternance de couches actives de composition différente (CAi) et de couches de confinement (CCi), toutes ces couches étant d'un même type de conductivité,

b) ménager dans l'empilement de ce bloc des rubans parallèles et allongés (RUBi), contenant respectivement, au voisinage de couches actives ayant un rang différent au moins dans deux rubans voisins, des jonctions P-N (Ji), électriquement commandables individuellement et isolées les unes des autres,

c) préparer optiquement les petites extrémités opposées (PEi) desdits rubans,
caractérisé en ce que l'étape b) comprend l'introduction d'impuretés, d'un type de conductivité opposé à celui des couches de confinement, au travers d'une couche supérieure quasi-plane (CS) formée sur une partie au moins de la surface supérieure (SS) de l'empilement et présentant le même type de conductivité que lesdites impuretés ou bien une faible conductivité de type opposé.

2. - Procédé selon la revendication 1, caractérisé en ce que l'étape a) comprend une opération de réalisation d'un substrat quasi-plan (S-1) et une opération de formation d'un empilement présentant une surface libre quasi-plane (SS-1), constituant la surface supérieure du bloc.

3. - Procédé selon la revendication 1, caractérisé en ce que l'étape a) comprend une opération de réalisation d'un substrat (S-2) présentant des marches allongées (Mi-2), parallèles entre elles et aux rubans, et séparées les unes des autres par des transitions (CMij), ainsi qu'une opération de formation d'un empilement présentant des paliers (PAL-2) parallèles auxdites marches,
et en ce que l'étape a) comprend ensuite une opération de nivellement de l'empilement, antérieure à l'opération de formation de ladite couche supérieure, destinée à obtenir une surface supérieure de l'empilement quasi-plane (SS-2), constituant la surface supérieure du bloc.

4. - Procédé selon la revendication 3, caractérisé en ce que l'opération de nivellement comprend un décapage par photogravure.

5. - Procédé selon l'une des revendications 1 à 4, caractérisé en ce que les matériaux constituant la double hétérostructure sont des alliages III-V.

6. - Procédé selon la revendication 5, caractérisé en ce que les matériaux constituant la double hétérostructure sont des alliages d'au moins un matériau du groupe : aluminium, gallium, et indium; et d'au moins un matériau du groupe : phosphore, arsenic, antimoine.

7. - Procédé selon la revendication 6, caractérisé en ce que les couches actives, de type N, ont pour composition $Ga_{1-x}$, $Al_x$ As, x différant à chaque fois, et étant inférieur à 10% environ, tandis que les couches de confinement ont pour composition $Ga_{1-y}$, $Al_y$ As, y étant sensiblement le même pour toutes, et égal à 30% environ.

8. - Procédé selon l'une des revendications précédentes, caractérisé en ce que les couches de la double hétérostructure sont déposées par épitaxie, en particulier par épitaxie en phase liquide, ou encore par épitaxie par jet moléculaire, ou bien par dépôt en phase vapeur de composés organométalliques.

9. - Procédé selon l'une des revendications précédentes, caractérisé en ce que l'épaisseur des couches actives est de l'ordre du dixième de micromètre, tandis que celle des couches de confinement est de l'ordre du micromètre.

10. - Procédé selon l'une des revendications 2 à 9, caractérisé en ce que, dans l'étape b), ladite couche supérieure (CS) est surajoutée sur une partie au moins de ladite surface supérieure quasi-plane du bloc par un dépôt par épitaxie.

11. - Procédé selon la revendication 10, caractérisé en ce que l'épaisseur de la couche supérieure est de l'ordre du dixième de micromètre.

12. - Procédé selon l'une des revendications précédentes, caractérisé en ce que la couche supérieure est également un alliage III-V.

13. - Procédé selon la revendication 12, prise en combinaison avec la revendication 7, caractérisé en ce que la couche de contact est en arséniure de gallium de type P.

14. - Procédé selon l'une des revendications 2 à 9, caractérisé en ce que l'étape b) comprend une opération de décapage de la surface supérieure du bloc mettant à nu au moins sur la majeure partie de la surface ainsi décapée de l'empilement le niveau supérieur d'une couche active, celle-ci servant alors de couche de contact.

14. - Procédé selon l'une des revendications précédentes, caractérisé en ce que, dans l'étape b), on forme, par introduction d'impuretés, des régions de type inversé (Ri) s'étendant depuis la couche supérieure jusqu'à la couche active de rang souhaité pour former respectivement lesdites jonctions P-N (Ji).

15. - Procédé selon la revendication 14, caractérisé en ce que lesdites régions sont formées à l'aide d'impuretés choisies dans le groupe comprenant : zinc, cadmium, magnésium et béryllium.

16. - Procédé selon l'une des revendications 14 et 15, caractérisé en ce que lesdites régions sont localisées.

17. - Procédé selon l'une des revendications 14 et 15, caractérisé en ce que lesdites régions forment une zone continue unique de type inversé.

18. - Procédé selon l'une des revendications 14 à 17, caractérisé en ce que lesdites régions sont formées par diffusion.

19. - Procédé selon l'une des revendications 14 à 17, caractérisé en ce que lesdites régions sont formées par implantation ionique suivie de recuit.

20. - Procédé selon l'une des revendications 14 à 19, caractérisé en ce que, dans l'étape b), on isole électriquement les jonctions P-N les unes des autres en réalisant un décapage localisé entre lesdites régions de type inversé, par voie sèche ou humide, de façon à graver des sillons (Vij) s'étendant depuis ladite couche supérieure jusqu'au moins au-delà de chaque jonction P-N située de part et d'autre du sillon correspondant, ce qui permet de ménager ainsi lesdits rubans (RUBi).

21. - Procédé selon l'une des revendications 14 à 19, caractérisé en ce que, dans l'étape b), on isole électriquement lesdites jonctions P-N en réalisant une implantation protonique entre lesdites régions de type inversé de façon à ménager ainsi lesdits rubans (RUBi).

22. - Procédé selon l'une des revendications 14 à 21, caractérisé en ce que l'étape b) comprend un dépôt métallique de contact individuel (DMIi) sur chaque région de type inversé (Ri) et un dépôt métallique de contact commun (DMS) sur le substrat.

23. - Procédé selon l'une des revendications précédentes, caractérisé en ce que l'étape c) de préparation optique comprend un clivage.

24. - Procédé selon l'une des revendications précédentes, caractérisé en ce que l'étape c) de préparation optique comprend un usinage par voie humide ou sèche.

25. - Procédé selon l'une des revendications précédentes, caractérisé en ce que le substrat comprend un alliage III-V (CT) fortement dopé de même type de conductivité que les couches de l'empilement, en contact avec la couche de confinement inférieure de cet empilement.

26. - Procédé selon la revendication 25, caractérisé en ce que le substrat comprend, en outre, un alliage III-V ou bien du silicium.

27. - Procédé selon l'une des revendications 3 à 26, caractérisé en ce que l'opération de réalisation du substrat (S-3) comprend en outre la formation d'une contre-marche transversale (CMIS-3) s'étendant dans un plan sensiblement perpendiculaire à chaque transition (CMij-3) et définissant sur ce substrat des fonds inférieur (FDI-3) et supérieur (FDS-3) pour ledit empilement, et en ce qu'il comprend une étape supplémentaire de réalisation, au sein de l'empilement, au moins dans le secteur supporté par le fond supérieur, d'une couche transparente (CG-3) formant guide de lumière pour les émissions lumineuses émises par les jonctions P-N.

28. - Dispositif semi-conducteur, comprenant sur un substrat, au moins deux empilements de double hétérostructure comportant chacun au moins une couche active encadrée par deux couches de confinement, ces deux empilements étant en forme de rubans allongés disposés côte-à-côte, électriquement isolés l'un de l'autre, comportant chacun une jonction P-N, électriquement commandable individuellement et située au voisinage d'une couche active de composition différente pour les deux empilements, les petites extrémités opposées de ces rubans étant préparées optiquement, caractérisé en ce que la surface supérieure du dispositif, opposée à la semelle du substrat, est quasi-plane.

29. - Dispositif selon la revendication 28, caractérisé en ce que chaque empilement comprend le même nombre de couches.

30. - Dispositif selon la revendication 28, caractérisé en ce que chaque empilement comprend un nombre différent de couches et en ce que le substrat présente des marches allongées, parallèles entre elles et aux rubans, et séparées les unes des autres par des transitions.

31. - Dispositif selon la revendication 30, caractérisé en ce que le substrat comporte en outre une contre-marche transversale s'étendant dans un plan sensiblement perpendiculaire aux marches et à chaque transition et définissant sur ce substrat des fonds inférieur et supérieur pour ledit empilement et en ce qu'il comporte, au moins dans le secteur supporté par le fond supérieur, une couche transparente formant guide de lumière pour les émissions lumineuses émises par les jonctions P-N.

FIG.1

FIG.2

FIG.3

FIG.4

FIG.5

FIG.6

CC4-2
CC3-2
CC2-2
CC1-2

CA3-2 CA2-2 PAL3-2   PAL 2-2   BL - 2   PAL1-2

CA1-2   M3-2   CM32-2   M2-2   CM21-2   S-2   M1-2

**FIG.7**

CC4-2
CC3-2
CC2-2
CC1-2

CA3-2   CA2-2   CA 1-2   SS-2

M3-2   M2-2   S-2   M1-2

**FIG.8**

CC4-2

CS-2   CA3-2   CA2-2   CA1-2

S-2

**FIG.9**

CA3-2   R3-2 J3-2  CS -2   J2-2  R2-2   CA1-2   J1-2   R1-2

CA2-2

S-2

**FIG.10**

FIG.11

FIG.12

FIG.13

## FIG.14

## FIG.15

CC3-3 CA2-3
DMI1-3 J1-3
R1-3
CS-3
J2-3
DMI2-3
R2-3
CC2-3
CA1-3
CC1-3
CG-3
CC0-3
CT-3
FDI-3 M1-3
BGU1-3 GU-3
M2-3
CS-3
CG-3
BGU2-3 CC1-3
CT-3 CC0-3
S-3

EP 0 380 380 A1

FIG.16

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 267 839  (L. MENIGAUX) <br> * En entier * | 1,2,5-8 ,12,13, 20,22, 25,26, 28,29 | H 01 L   33/00 <br> H 01 L   27/15 <br> H 01 S    3/25 |
| A | | 4,9-11, 14-16, 18,19, 21,23, 24 | |
| | --- | | |
| Y | ELECTRONICS LETTERS, vol. 18, no. 20, 30th septembre 1982, pages 871-873, Londres, GB; M. BOUADMA et al.: "Dual-wavelenght (GaAl)As laser" <br> * En entier * | 1,2,5-8 ,12,13, 20,22, 25,26, 28,29 | |
| | --- | | |
| A | ELECTRONICS LETTERS, vol. 24, no. 4, 18 février 1988, pages 217-219, Stevenage, Herts, GB; L.A. KOSZI et al.: "1.5 mum InP/GaInAsP linear laser array with twelve individually addressable elements" <br> * En entier * | 1,2,5,6 ,8,12, 20,22, 25,26, 28,29 | **DOMAINES TECHNIQUES RECHERCHES (Int. Cl.5)** <br><br> H 01 L <br> H 01 S |
| | --- | | |
| A | GB-A-2 187 330  (SHARP K.K.) <br> * Revendications; figures * | 1,27,31 | |
| | --- | | |
| A | PATENT ABSTRACTS OF JAPAN, vol. 11, no. 88 (E-490)[2535], 18 mars 1987; & JP-A-61 242 089 (MATSUSHITA ELECTRIC IND. CO., LTD) 28-10-1986 <br> * En entier * | 1,3 | |
| | ---                              -/- | | |

Le présent rapport a été établi pour toutes les revendications

| Lieu de la recherche | Date d'achèvement de la recherche | Examinateur |
|---|---|---|
| LA HAYE | 08-03-1990 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN, vol. 5, no. 167 (E-79)[839], 24 octobre 1981; & JP-A-56 96 881 (FUJITSU K.K.) 05-08-1981 ----- | | |
| | | | **DOMAINES TECHNIQUES RECHERCHES (Int. Cl.5)** |

Le présent rapport a été établi pour toutes les revendications

| Lieu de la recherche | Date d'achèvement de la recherche | Examinateur |
|---|---|---|
| LA HAYE | 08-03-1990 | VISENTIN A. |